# EUROPEAN PATENT APPLICATION

(11) **EP 2 587 538 A1**
(43) Date of publication of application: **01.05.2013**
(21) Application number: 12166533.5
(22) Date of filing: 03.05.2012
(51) Int. Cl.: H01L 25/075

(54) **A light emitting diode array**

(30) Priority: 26.10.2011 TW 100138893
(71) Applicant: Phostek, Inc., Taipei City 110 (TW)
(72) Inventor: Shao, Shih-Feng, 241 New Taipei City (TW); Liu, Heng, Sunnyvale, CA 94087 (US)
(74) Representative: Baldwin, Mark

(57) **Abstract**

A light emitting diode array comprises a plurality of light emitting diode units connected in series and arranged for forming an array with n rows and m columns. At least one of the numbers m and n of the array is an odd number.

## Description

### CROSS-REFERENCES TO RELATED APPLICATIONS

This non-provisional application claims priority on Patent Application No. 100138893 filed in Taiwan, R.O.C. on October 26, 2011, the entire contents of which are hereby incorporated by reference.

### FIELD OF THE INVENTION

The present invention is related to a light emitting diode array, particularly to a light emitting diode array comprising a plurality of light emitting diode units connected in series.

### BACKGROUND

The light emitting diode (LED) is widely used in indicators, billboards, traffic lights, car lamps, display panels, communication apparatus, and indoor lighting for the advantages of long lifetime, small size, low power consumption and quick response.

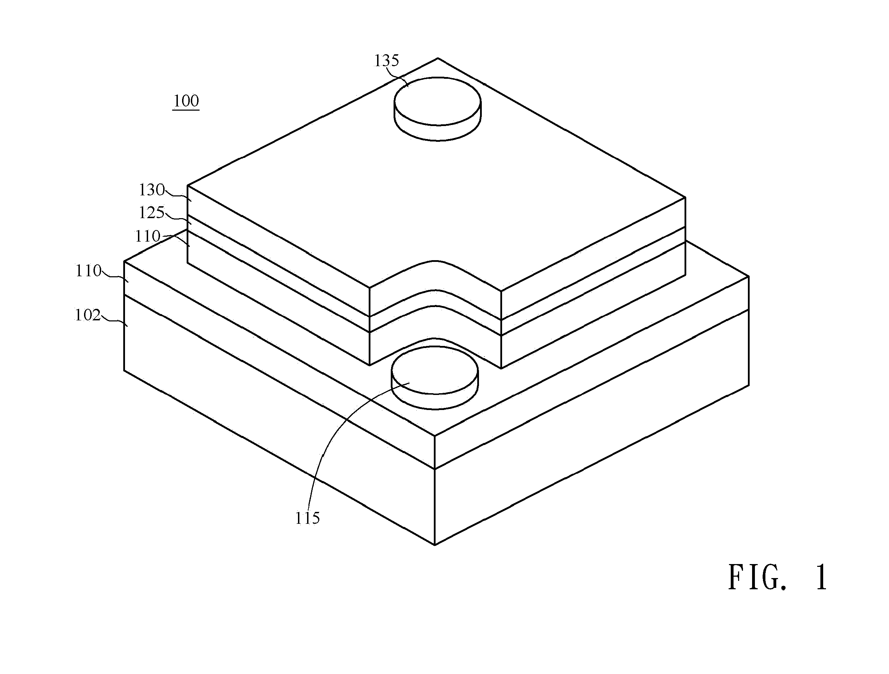

Referring to Fig. 1, there is a schematic diagram of a conventional LED. The LED chip 100 comprises a substrate 102, an N-type layer 110, a light emitting layer 125, and a P-type layer 130. A first electrode 115 and a second electrode 135 are formed on and electrically coupled to the N-type layer 110 and the P-type layer 130, respectively. When an appropriate voltage is applied between the first electrode 115 and the second electrode 135, the electrons in the N-type layer 110 will move and recombine with the holes from the P-type layer 130 in the light emitting layer 125 and light emits from the light emitting layer 125.

The substrate 102 is made of sapphire. The N-type layer 110 is made of silicon doped aluminum gallium nitride (AlGaN) or silicon doped gallium nitride (GaN). The P-type layer 130 is made of magnesium doped AlGaN or magnesium doped GaN. The light emitting layer 125 is made of single quantum well or multiple quantum well structure material such as indium gallium nitride (InGaN) or GaN.

In general, the voltage is needed to provide 3 volts DC voltage between the first electrode 115 and the second electrode 135 to drive the LED chip 100. For example, in a single LED chip flashlight, two 1.5 volt batteries connected in series can drive the LED chip 100 to emit light.

However, when using the domestic power to drive the LED chip 100, a voltage transformation will be needed. Currently domestic power is between 100 volts and 220 volts AC power. Consequently, the domestic power should be transformed and rectified for driving the LED chip 100.

Since the voltage of the domestic power is too much higher than the driving voltage of the LED chip 100, and the power transformation efficiency is low, so the power consumption is high for the transformation.

### SUMMARY OF THE INVENTION

It is one object of the present invention to provide a light emitting diode (LED) array comprising a plurality of LED units connected in series. By increasing the number of the LED units, the driving voltage will be increased, and the power consumption for transformation will be reduced.

It is another object of the present invention to provide an LED array comprising a plurality of LED units arranged to form an array with n rows and m columns, wherein at least one of the numbers n and m of the array is an odd number. Consequently, the current input point and the current output point are disposed at the edge or corners of the LED array. That is beneficial for coupling the LED array with the power supply.

It is another object of the present invention to provide an LED array comprising a plurality of LED units connected in series. That is beneficial for using the domestic power to drive the LED array and using the LED array as the fixed illumination light source.

It is another object of the present invention to provide an LED array, wherein each LED unit is quadrilateral, such as quasi-parallelogram, quasi-rectangle, quasi-square, quasi-rhombus, and etc. The plurality of LED units are arranged to form an array, and the electrodes are disposed diagonally for uniform current spreading and the uniformity of the light source.

The present invention provides a light emitting diode (LED) array comprising: a plurality of LED units connected in series and arranged to form an array with n rows and m columns, wherein at least one of the numbers n and m is an odd number.

In one embodiment of the present invention, wherein each of said LED units is quadrilateral and comprises a first electrode and a second electrode, wherein the first electrode is disposed on or near a first corner of the quadrilateral and the second electrode is disposed on or near a second corner of the quadrilateral, and the first corner and the second corner are in a diagonal position.

In one embodiment of the present invention, wherein each of said LED units is quasi-square and comprises a first electrode and a second electrode, wherein the first electrode is disposed on or near a first corner of the quasi-square and the second electrode is disposed on or near a second corner of the quasi-square, and the first corner and the second corner are in a diagonal position.

In one embodiment of the present invention, wherein said LED array is quadrilateral and is connected to a current input point and a current output point.

In one embodiment of the present invention, wherein said LED array is quasi-square and is connected to the current input point and the current output point.

In one embodiment of the present invention, wherein said plurality of LED units connected in series comprises a first LED unit and a last LED unit, wherein the second electrode of the first LED unit is connected to the current input point, and the first electrode of the last LED unit is connected to the current output point.

In one embodiment of the present invention, wherein one of said numbers m and n is an odd number and the other is an even number, wherein said current input point and said current output point are disposed on or near adjacent corners of said LED array.

In one embodiment of the present invention, wherein said numbers m and n are odd numbers, wherein said current input point and said current output point are disposed on or near corners of said LED array in diagonal position.

In one embodiment of the present invention, wherein said plurality of LED units connected in series comprises a first LED unit and a third LED unit, wherein a first relative position of the first electrode and the second electrode of the third LED unit is the same as a third relative position of the first electrode and the second electrode of the first LED unit.

In one embodiment of the present invention, wherein said plurality of LED units connected in series further comprises a second LED unit, wherein a second relative position of the first electrode and the second electrode of the second LED unit is the same as the first relative position of the first electrode and the second electrode of the first LED unit with 90 degree rotation clockwise, the third relative position of the first electrode and the second electrode of the third LED unit is the same as the second relative position of the first electrode and the second electrode of the second LED unit with 90 degree rotation counterclockwise.

In one embodiment of the present invention, further comprises a substrate, wherein said plurality of LED units is disposed on said substrate.

In one embodiment of the present invention, further comprises a plurality of bonding wires for connecting adjacent LED units of said plurality of LED units in series.

In one embodiment of the present invention, further comprises a plurality of interconnects for connecting adjacent LED units of said plurality of LED units in series.

In one embodiment of the present invention, wherein each of said plurality of interconnects is disposed along the minimum distance between the electrodes of the adjacent LED units.

In one embodiment of the present invention, wherein each of said plurality of LED units is formed a stacking LEDs.

In one embodiment of the present invention, wherein said stacking LEDs comprises said plurality of LEDs connected in series vertically.

In one embodiment of the present invention, wherein each of said stacking LEDs comprises a first electrode disposed on an LED of said stacking LEDs adjacent to the substrate and a second electrode disposed on a top LED of said stacking LEDs.

In one embodiment of the present invention, wherein said stacking LEDs comprises said plurality of LEDs connected in parallel vertically.

### BRIEF DESCRIPTION OF DRAWINGS

Fig. 1 is a schematic diagram of a conventional LED.
Fig. 2 is a schematic diagram in accordance with a first embodiment of the present invention.
Fig. 3 is a plan view of the embodiment of Fig 2.
Fig. 4 is a plan view in accordance of a second embodiment of the present invention.
Fig. 5 is a plan view in accordance with a third embodiment of the present invention.
Fig. 6 is a plan view in accordance with a fourth embodiment of the present invention.
Fig. 7 is a cross-sectional view of an LED unit in accordance with another embodiment of the present invention.

### DETAILED DESCRIPTION

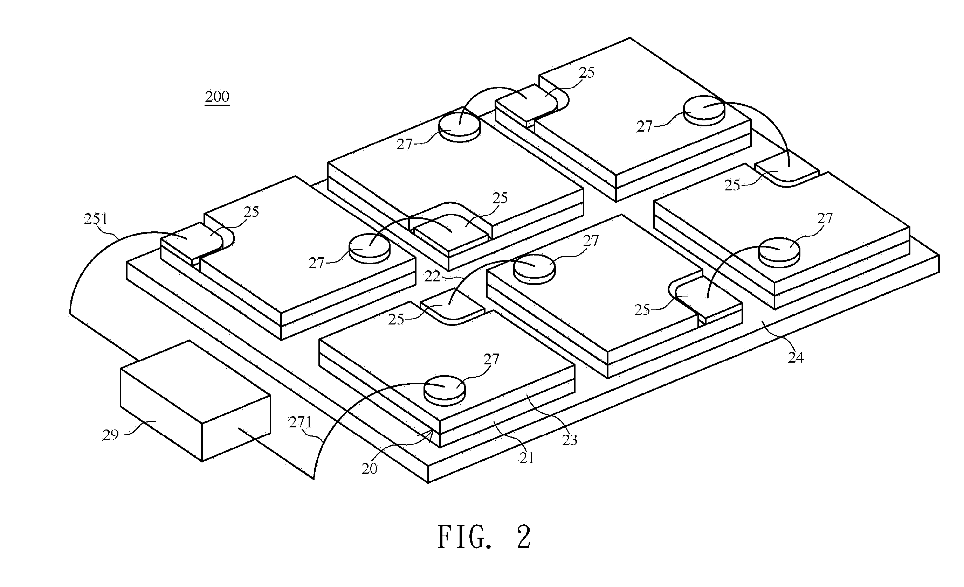

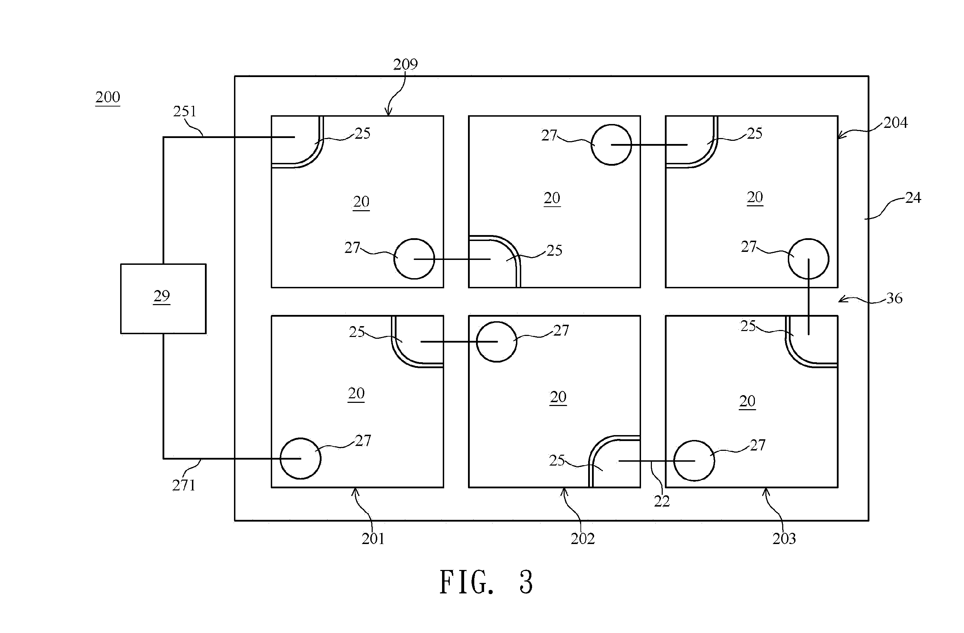

Referring to Fig. 2 and Fig. 3, there are shown a schematic diagram and a plan view in accordance with one embodiment of the present invention. The light emitting diode (LED) array 200 of the present invention comprises a plurality of LED units 20. The plurality of LED units 20 are connected in series, and can be driven by a power supply 29.

In one embodiment of the present invention, the plurality of LED units 20 is configured to form an array on a substrate 24. The LED units 20 are separated from each other by gaps. The LED array 200 comprises n rows and m columns, wherein at least one of the numbers n and m of the array is an odd number. In one embodiment of the present invention, the LED array 200 comprises 2 rows and 3 columns.

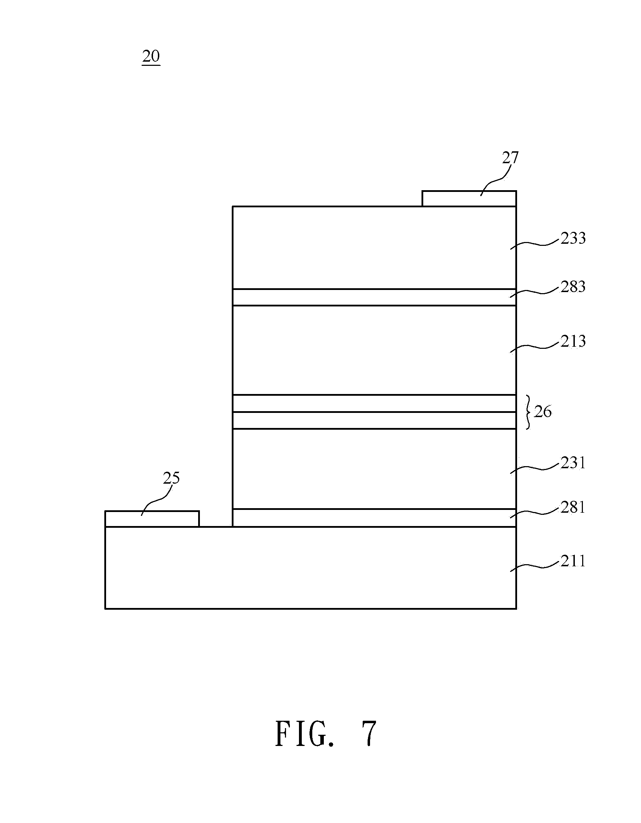

In one embodiment of the present invention, each of the LED units 20 comprises a first material layer 21, a second material layer 23, at least one first electrode 25, and at least one second electrode 27. The first material layer 21 and the second material layer 23 are stacked, and the second material layer 23 is disposed on a part of the surface of the first material layer 21. The first electrode 25 is disposed on the other part of the surface of the first material layer 21 and is separated from the second material layer 23. The second electrode 27 is disposed on a part of the surface of the second material layer 23. When an appropriate voltage is provided between the first electrode 25 and the second electrode 27, the LED units 20 will be driven to emit light. In another embodiment of the present invention, the LED units 20 can be stacking LEDs as discussed below in connection with Fig 7.

In one embodiment of the present invention, each of the LED units 20 is quadrilateral, such as quasi-parallelogram, quasi-rectangle, quasi-square, quasi-rhombus, and etc. The first electrode 25 is disposed on or near a first corner of the quadrilateral and the second electrode 27 is disposed on or near a second corner of the quadrilateral, and the first corner and the second corner are in a diagonal opposed position for uniform current spreading and the uniformity of light emission by each of the LED units 20. Moreover, the diagonal configuration of the first electrode 25 and the second electrode 27 is beneficial for the electrical coupling between the adjacent LED units 20.

By arranging the above-mentioned shapes of LED units 20, the LED array 200 can be formed quadrilateral, quasi-parallelogram, quasi-rectangle, quasi-square, quasi-rhombus etc.

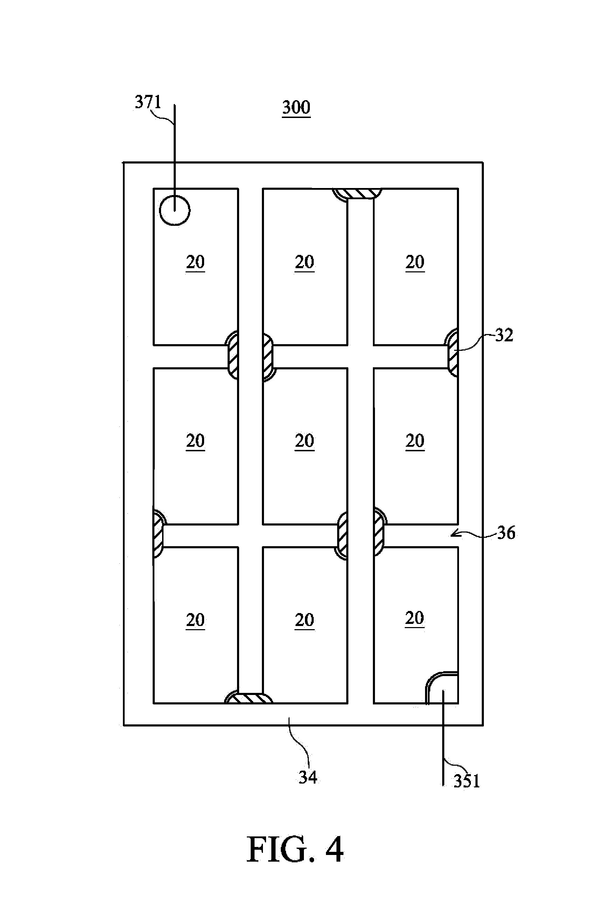

Referring to Fig. 3, in one embodiment of the present invention, the relative positions of the electrodes of the LED units 20 should be taken into consideration for arranging the LED units 20 to form the LED array 200. For example, the second relative position of the electrodes of the second LED unit 202 should be the same as the first relative position of the electrodes of the first LED unit 201 with 90 degree rotation clockwise; and the third relative position of the electrodes of the third LED unit 203 should be the same as the second relative position of the electrodes of the second LED unit 202 with 90 degree rotation counterclockwise. In other words, the third relative position of the electrodes of the third LED unit 203 is the same as the first relative position of the electrodes of the first LED unit 201. This configuration provides the minimum distance between the electrodes of the adjacent LED units 20. Consequently, the length of the bonding wires 22 or interconnects 32 (Fig 4) can be minimized, and the resistance value and cost can be reduced. For example, the second electrode 27 of the second LED unit 202 is adjacent to the first electrode 25 of the first LED unit 201, and the second electrode 27 of the third LED unit 203 is adjacent to the first electrode 25 of the second LED unit 202.

In one embodiment of the present invention, the LED array 200 comprises m rows and n columns, wherein at least one of the numbers m and n of the array is an odd number. This configuration provides minimum distance between the electrodes of the adjacent LED units 20 for cross-column or cross-row connection. Consequently, the length of the bonding wires 22 or interconnects 32 can be minimized, and the resistance value and cost can be reduced. For example shown in Fig. 3, the second electrode 27 of the fourth LED unit 204 is adjacent to the first electrode 25 of the third LED unit 203.

Referring to Fig. 2 and Fig. 3, a bonding wire 22 is used to connect the adjacent LED units 20 with a gap for larger distance. Referring to Fig. 4, an interconnect 32 is used to connect the adjacent LED unit 20 with a gap 36 for smaller distance.

For an LED array 300 with interconnects 32 as shown in Fig 4, the plurality of LED units 20 are disposed on an insulation substrate 34 or a high resistance substrate 34, such as sapphire, silicon carbide, or other nitrides, to form an LED array 300. Each of the LED units 20 is separated from each other by gaps 36. The electrodes of the adjacent LED units 20 are connected by an interconnect 32. In general, for the ensuring the insulation of each of the LED units 20, an insulation material is deposited on the LED array 300 firstly, and then the interconnects 32 are deposited to connect the electrodes. The interconnects 32 are usually made of metal.

In one embodiment of the present invention, the LED array 200 comprises a current input point 271 and a current output point 251. The power supply 29 is connected to the current input point 271 and current output point 251 of the LED array 200 for providing current to each of the LED units 20. Referring to Fig. 3 and Fig. 4, the quasi-square or quasi-rectangle LED units 20 can be arranged to form an LED array 200 of quasi-square or quasi-rectangle. The current input point 271 and current output point 251 of the LED array 200 are disposed at the adjacent corners or diagonal corners. For example, the second electrode 27 of the first LED unit 201 is connected to the current input point 271, and the first electrode 25 of the last LED unit 209 is connected to the current output point 251.

The power supply 29, such as a DC power supply, is used for voltage transformation and rectification. A domestic power supply between 100 volts and 220 volts AC can be transformed and rectified to an appropriate voltage DC power to drive the LED array 200.

In one embodiment of the present invention, the plurality of LED units 20 are connected in series to form the LED array 200, the driving voltage of the LED array 200 is the summation of the LED units 20. The power consumption of voltage transformation of the power supply 29 is reduced. For example, the LED array 200 shown in Fig. 3 comprises 6 LED units 20 connected in series. The driving voltage of each LED unit 20 is about 3 volts. The driving voltage of the LED array 200 is about 18 volts (3 volts multiplied by 6). Consequently, the power supply 29 transforms a domestic power supply ofbetween 110 volts or 220 volts AC to 18 volts DC to drive the LED array 200.

In the above-mentioned embodiment, an LED array 200 comprising 6 LED units 20 is illustrated. In practical applications, the number of LED units can be increased. That will be illustrated in the following embodiments. By increasing the number of LED units 20 connected in series, the driving voltage of the LED array 200 can be increased, and the light emitting area and the brightness of the LED array are increased.

Furthermore, in one embodiment of the present invention, the LED array 200 comprises a plurality of LED units 20 of the same colour for providing light of single color. In anther embodiment of the present invention, the LED array 200 comprises a plurality of LED units 20 with different colours for providing light of multiple colours, such as red light, green light, blue light, etc.

Referring to Fig. 4, there is shown a plan view in accordance with a second embodiment of the present invention. The LED array 300 of the present invention comprises a plurality of LED units 20 arranged to form an array on a substrate 34 with 3 rows and 3 columns.

The LED units 20 of the LED array 300 are connected in series by interconnects 32. In practical application, the LED units 20 of the LED array 300 are configured to provide the minimum distance between the electrodes of the adjacent LED units 20, that the lengths of the interconnects 32 are minimised. The sizes of the interconnect 32, the first electrode 25, and the second electrode 27 can be reduced to increase the light emitting area. The areas of the current input point 371 and the current output point 351 can be larger for being beneficial to electrically couple with an external device. By connecting 9 LED units 20 in series, the driving voltage of the LED array 300 is increased to about 27 volts, that the power consumption of voltage transformation can be further reduced.

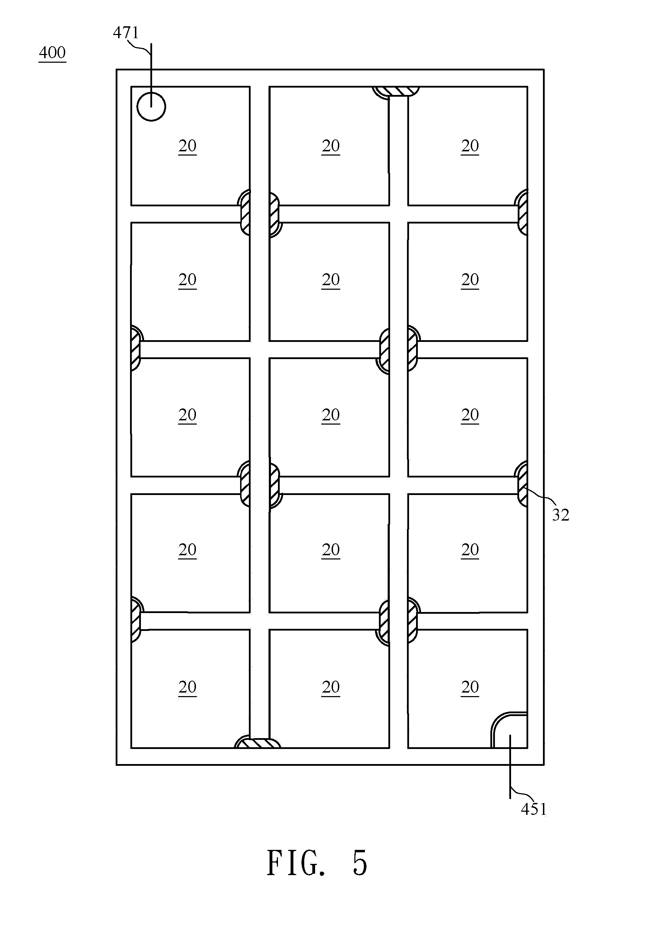

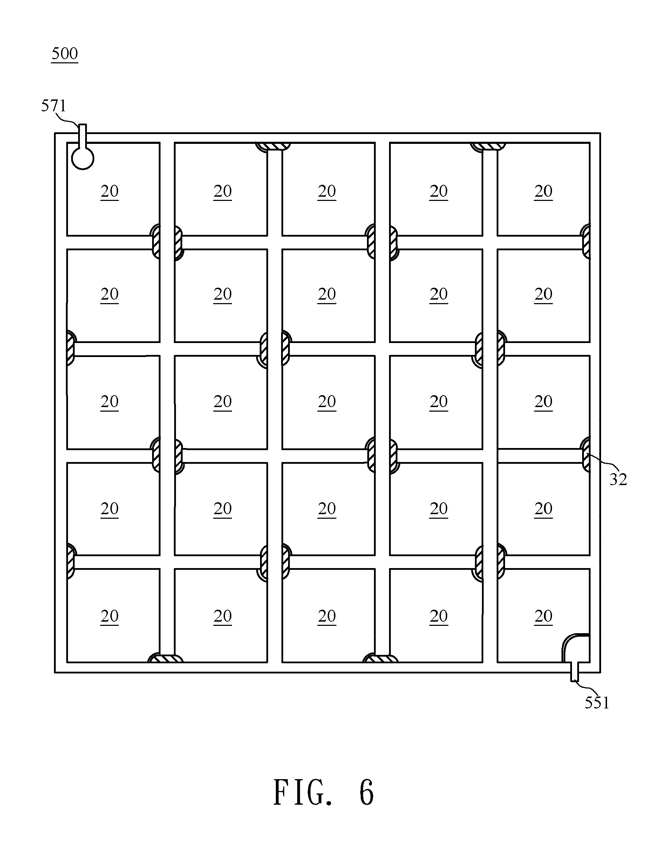

Referring to Fig 5, in a third embodiment of the present invention the number of the LED units 20 can be further increased. For example, 15 LED units 20 are connected in series to form an LED array 400 with 5 rows and 3 columns. The driving voltage of the LED array 400 is about 45 volts. In a fourth embodiment of the present invention, 25 LED units 20 are connected in series to form an LED array 500 with 5 rows and 5 columns, as shown in Fig. 6. The driving voltage of the LED array 500 is about 75 volts.

In one embodiment of the present invention, each of LED unit 20 is quasi-square. When the number m of the rows of the LED array 200 is equal to the number n of the columns of the LED array 200, the LED array 200 is quasi-square. When the number m is not equal to the number n, the LED array 200 is quasi-rectangular or oblong.

In one embodiment of the present invention, when one of the number n and number m is an odd number and the other is an even number, the current input point 271 and the current output point 251 are disposed at the adjacent corners of the LED array 200, as shown in Fig. 3. When the numbers n and m are odd numbers, the current input point 371, 471, 571 and the current output point 351, 451, 551 of the LED array 300, 400, 500 are disposed at diagonally opposed corners, as shown in Fig. 4, 5, and 6. The configuration of the LED array 300, 400, 500 is suitable for electrically coupling to a general lead frame.

Referring to Fig 7, in embodiments of the present invention the LED unit 20 can be stacking LEDs which comprises a plurality of LEDs stacked and connected in series or in parallel vertically. The first electrode 25 is disposed on the LED adjacent to the substrate, and the second electrode 27 is disposed on the top LED, as shown in Fig. 7.

The LED unit 20 comprises a first N-type semiconductor layer 211, a first P-type semiconductor 231 a tunnel junction 26, a second N-type semiconductor layer 213, and a second P-type semiconductor layer 233 stacked. There are a first active layer 281 between the first N-type semiconductor layer 211 and the first P-type semiconductor layer 231 and a second active layer 283 between the second N-type semiconductor layer 213 and the second P-type semiconductor layer 233. The first electrode 25 is disposed on the surface of the first N-type semiconductor layer 211 of the LED adjacent to the substrate. The second electrode 27 is disposed on the surface of the second P-type semiconductor layer 233 of the top LED. In the present embodiment, the LED unit 20 comprises 2 LEDs stacked, and a tunnel junction 26 between the 2 LEDs. In another embodiment of the present invention, the LED unit 20 can comprise more LEDs stacked, wherein tunnel junctions 26 are disposed between adjacent LEDs.

In the illustrated embodiments it can be seen that there are LED arrays that comprises a plurality of arrays arranged to form a structure that in plan is a quadrilateral. In the illustrated embodiments the quadrilateral is a rectangle and examples are shown of square and oblong arrays. It will be understood that it is not essential that the structure is a quadrilateral in the strict geometric definition of the term. For example, the structure may have rounded corners or sides that are not exactly straight so that the shape can be said to be a quasi-quadrilateral or substantially quadrilateral. Thus, for example, the arrays may be substantially rectangular or a quasi-rectangle. Similarly, the LEDs of the embodiments are quadrilaterals and examples of square rectangular LEDs are illustrated. It will be understood that in similar fashion the LEDs may be quasi, or substantially, quadrilateral.

It will be appreciated that embodiments are illustrated in which the LEDs of the LED arrays are connected in series and the LEDs of the series are arranged such that alternate LEDs are rotated through substantially 90 degrees with respect to their immediately preceding and succeeding neighbours to permit the connections therebetween to be kept relatively short by, preferably, following the shortest distance between adjacent electrodes.

The foregoing description is merely embodiments of the present invention and not considered as restrictive. All equivalent variations and modifications in shape, structure, feature, and spirit in accordance with the appended claims may be made without departing from the scope of the invention.

## Claims

1. A light emitting diode (LED) array comprising:
a plurality of LED units (20) connected in series and arranged to form an array with n rows and m columns, wherein at least one of the numbers n and m is an odd number.

2. The LED array according to Claim 1, wherein each of said LED units (20) is a quadrilateral and comprises a first electrode (25) and a second electrode (27), the first electrode (25) is disposed on or near a first corner of the quadrilateral, the second electrode is disposed on or near a second corner of the quadrilateral and the first corner and the second corner are in a diagonally opposed positions.

3. The LED array according to Claim 2, wherein each of said LED units (20) is quasi-square.

4. The LED array according to Claim 2 or 3, wherein said LED array is quadrilateral and is connected to a current input point (271, 371, 471, 571) and a current output point (251, 351, 451, 551).

5. The LED array according to Claim 4, wherein said LED array is quasi-square.

6. The LED array according to Claim 4 or 5, wherein said plurality of LED units (20) is connected in series and comprises a first LED unit (201) and a last LED unit (209), wherein the second electrode (27) of the first LED unit (201) is connected to the current input point (271) and the first electrode (25) of the last LED unit (209) is connected to the current output point (251).

7. The LED array according to Claim 4, 5 or 6, wherein one of said numbers m and n is an odd number and the other is an even number and said current input point (271, 371, 471, 571) and said current output point (251, 351, 451, 551) are disposed on or near adjacent corners of said LED array.

8. The LED array according to Claim 4, 5 or 6, wherein both of said numbers m and n are odd numbers and said current input point (271, 371, 471, 571) and said current output point (251, 351, 451, 551) are disposed on or near corners of said LED array in diagonally opposed relation.

9. The LED array according to Claim 4, wherein said plurality of LED units is connected in series and comprises a first LED unit (201) and a third LED unit (203), and wherein a first relative position of the first electrode (25) and the second electrode (27) of the third LED unit is the same as a third relative position of the first electrode (25) and the second electrode (27) of the first LED unit.

10. The LED array according to Claim 9, wherein said plurality of LED units connected in series further comprises a second LED unit (202), and wherein a second relative position of the first electrode (25) and the second electrode (27) of the second LED unit is the same as the first relative position of the first electrode and the second electrode of the first LED unit with 90 degree rotation clockwise.

11. The LED array according to any one of the preceding Claims, further comprising a plurality of bonding wires (22) for connecting adjacent LED units (20) of said plurality of LED units in series.

12. The LED array according to any one of Claims 1 to 10, further comprising a plurality of interconnects (32) for connecting adjacent LED units (20) of said plurality of LED units in series, each of said plurality of interconnects being disposed along the minimum distance between the electrodes of the adjacent LED units.

13. The LED array according to any one of the preceding Claims, further comprising a substrate (24), wherein said plurality of LED units (20) is disposed on said substrate and each of said plurality of LED units comprises a stack of LEDs.

14. The LED array according to Claim 13, wherein the LEDs of said stack are connected in series vertically.

15. The LED array according to Claim 13, wherein the LEDs of said stack of LEDs are connected in parallel vertically.
